# EUROPÄISCHE PATENTSCHRIFT

(11) **EP 2 291 484 B1**
(45) Veröffentlichungstag und Bekanntmachung des Hinweises auf die Patenterteilung: **20.06.2012**
(21) Anmeldenummer: 09799913.0
(22) Anmeldetag: 31.03.2009
(51) Int. Cl.: H01L 31/0232, H01L 51/44, C09K 11/06, F24J 2/06, H01L 31/055

(54) **LUMINESZENZKONZENTRATOREN UND LUMINESZENZDISPERGATOREN AUF DER BASIS ORIENTIERTER FARBSTOFF-ZEOLITH ANTENNEN**
LUMINESCENCE CONCENTRATORS AND LUMINESCENCE DISPERSERS ON THE BASIS OF ORIENTED DYE ZEOLITE ANTENNAS
CONCENTRATEURS DE LUMINESCENCE ET SYSTÈMES DISPERSANTS DE LUMINESCENCE À BASE D'ANTENNES COLORANT-ZÉOLITHE ORIENTÉES

(30) Priorität: 01.07.2008 CH 10162008
(43) Veröffentlichungstag der Anmeldung: 09.03.2011
(73) Patentinhaber: Calzaferri, Gion, 3047 Bremgarten (CH); Kunzmann, Andreas, 5603 Staufen (CH); Universität Zürich, 8057 Zürich (CH)
(72) Erfinder: BAUER, Christophe, 1700 Fribourg (CH); CALZAFERRI, Gion, 3047 Bremgarten (CH); KUNZMANN, Andreas c/o Optical Additives GmbH, 5603 Staufen (CH); BRÜHWILER, Dominik, 8965 Berikon (CH)
(74) Vertreter: Hepp Wenger Ryffel AG
(86) Internationale Anmeldenummer: PCT/CH2009/000074
(87) Internationale Veröffentlichungsnummer: WO 2010/009560

(56) Entgegenhaltungen:
- WO-A-2007/012216
- BRÜHWILER D; DIEU L-Q, CALZAFERRI G: CHIMIA, Bd. 61, Nr. 12, 2007, Seiten 820-822, XP001536989 in der Anmeldung erwähnt
- KOEPPE ET AL: "Advanced photon-harvesting concepts for low-energy gap organic solar cells" SOLAR ENERGY MATERIALS AND SOLAR CELLS, ELSEVIER SCIENCE PUBLISHERS, AMSTERDAM, NL, Bd. 91, Nr. 11, 26. April 2007 (2007-04-26), Seiten 986-995, XP022047682 ISSN: 0927-0248
- KOEPPE R ET AL: "Enhancing photon harvesting in organic solar cells with luminescent concentrators" APPLIED PHYSICS LETTERS, AIP, AMERICAN INSTITUTE OF PHYSICS, MELVILLE, NY, Bd. 90, Nr. 18, 4. Mai 2007 (2007-05-04), Seiten 181126-181126, XP012094469 ISSN: 0003-6951
- RUIZ ARANTZAZU ZABALA ET AL: "Organizing supramolecular functional dye-zeolite crystals" ANGEWANDTE CHEMIE. INTERNATIONAL EDITION, WILEY VCH VERLAG, WEINHEIM, Bd. 45, Nr. 32, 4. August 2006 (2006-08-04), Seiten 5282-5287, XP002411537 ISSN: 1433-7851 in der Anmeldung erwähnt

## Beschreibung

### Technisches Gebiet

Der Erfindungsgegenstand ist eine Vorrichtung zum Aufkonzentrieren, als Lumineszenzkonzentrator, oder zum Dispergieren, als Lumineszenzdispergator, gemäss Patentanspruch 1, ein Verfahren zu seiner Herstellung gemäss Patentanspruch 4 und seine Verwendung gemäss den Patentansprüchen 5, 6, 7, 8, 9, 10, 11, 12, 13.

### Stand der Technik

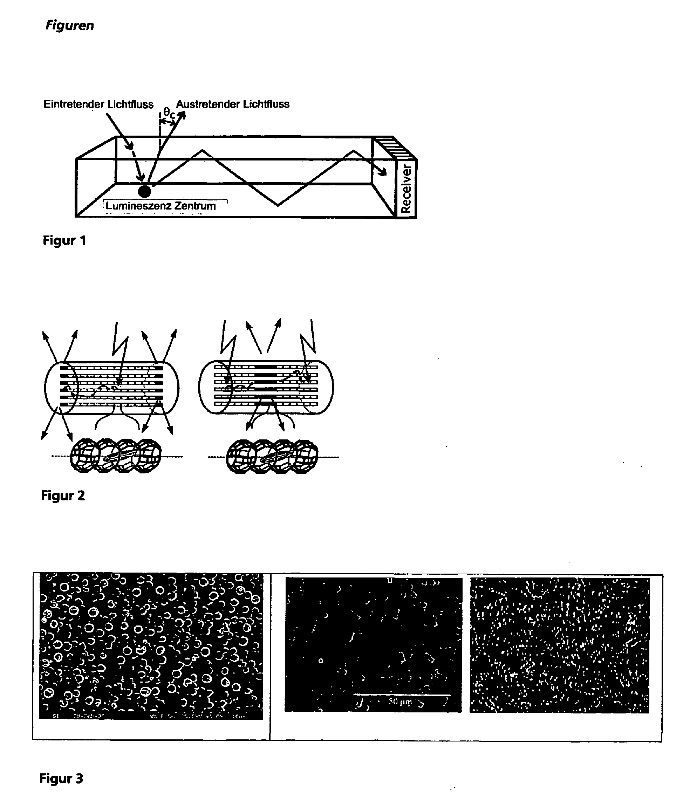

Ein Lumineszenzkonzentrator, den wir im Folgenden mit LK abkürzen, ist eine Vorrichtung, die sowohl einfallendes direktes als auch diffuses Licht durch Frequenzverschiebung und totale interne Reflexion aufkonzentrieren kann, siehe Figur 1. Diese Konzentrationsverfahren unterscheiden sich grundlegend von geometrischen Konzentratoren. Es ist nicht durch das Liouville'sche Theorem limitiert, nach welchem in einem geometrischen Konzentrator das Produkt aus Photonenflussdichte und Divergenz des Strahlungsflusses immer konstant bleibt. Bei genügender geometrischer Ausdehnung der Kollektorplatte lässt sich im LK im Prinzip eine fast beliebig hohe Konzentration erreichen. Vgl. dazu z.B. R. A. Garwin, Rev. Sci. Instr. 1960, 31, 1010; A. Goetzberger und V. Wittwer, Sonnenenergie, Teubner Studienbücher Physik, ISBN 3-519-03081-0, Verlag Teubner 1986; W. H. Weber, J. Lambe, Appl. Opt. 1976, 15, 2299; A. Goetzberger, W. Greubel, Appl. Phys. 1977, 14, 123; J. S. Batchelder, A. H. Zewail, T. Cole, Appl. Opt. 1979, 18, 3090; J. S. Batchelder, A. H. Zewail, T. Cole, Appl. Opt. 1981, 20, 3733; R. Koeppe, N. Sariciftci, A. Büchtemann, Appl. Phys. Lett. 90 (2007) 181126; P. Kittidachachan, L. Danos, T. J. J. Meyer, N. Alderman, T. Markvart, Chimia, 2007, 61, 780.

Ein invertierter Lumineszenzkonzentrator, den wir im Folgenden mit iLK abkürzen, ist eine Vorrichtung, die sowohl gerichtetes oder als auch ungerichtetes einfallendes Licht durch Frequenzverschiebung und totale interne Reflexion in einem durchsichtigen Körper (zum Beispiel Glas oder Kunststoff) gefangen hält und mittels Lumineszenzemission gleichmässig über eine Fläche verteilt diffus oder gerichtet abstrahlt, d.h. aus dem Körper auskoppelt. Ein iLK kann somit als Lumineszenzdispergator funktionieren

Die wesentlichen Probleme der heute bekannten LK sind: (A) der Verlust der bereits bei der Erstemission eintritt, weil totale interne Reflexion durch den halben Zylinderöffnungswinkel begrenzt ist; (B) die Eigenabsorption mit nachfolgender Reemission, die wiederum den gleichen Verlust zur Folge hat wie (A), und die zudem mit einer Ausbeute von etwas weniger als 100 % erfolgt; (C) die Notwendigkeit, die Chromophoren in einer relativ dicken Schicht von mehreren Millimetern zu verteilen (lösen), was für die Optimierung der optischen Eigenschaften der LK eine erhebliche Einschränkung bedeutet, und insbesondere einen strukturierten Aufbau mit Materialien von unterschiedlichem Brechungsindex verunmöglicht oder zumindest erheblich erschwert; (D) die Stabilität der in der Regel in einem Polymer gelösten Farbstoffe, die somit auch Weichmachern und andern reaktiven Spezies ausgesetzt sind und bei erheblichen Temperaturschwankungen sogar migrieren können. Dies sind Probleme, die den Wirkungsgrad, die Lebensdauer und die Flexibilität - beim Aufbau von Anordnungen, funktionellen Einheiten oder Apparaturen - und damit den Verwendungsbereich oder sogar die Verwendbarkeit von LK erheblich begrenzen oder sogar in Frage stellen; siehe die oben gegebenen Referenzen.

Das wesentliche Problem der heute bekannten auf Lichtstreuung beruhenden Verwendungen ist die gleichmässige Lichtemission über eine grössere Fläche, d.h. die Lichtemissionsintensität über eine Fläche gleichmässig zu verteilen. Dies wird zum Beispiel für Hintergrundbeleuchtungen bei LCD benötigt. Hintergrundbeleuchtung wird zur Hinterleuchtung von LC-Bildschirmen (LCDs) und -Anzeigen elektronischer Geräte eingesetzt. Beispiele sind digitale Messgeräte, Mobiltelefone oder Flachbildschirme von Fernsehgeräten und Monitoren. Bei LCD wird dadurch eine Kontraststeigerung gegenüber nicht selbstleuchtender, rein reflektiver Arbeitsweise erreicht. Der Zweck der Hintergrundbeleuchtung ist, den Bildschirm von hinten flach, gleichmässig und effizient zu beleuchten. Die Farbe der Lichtquelle muss bei Farbbildschirmen weiss sein (die einzelnen Farbpixel des LCD lassen ihre jeweilige Farbe passieren), wohingegen sie bei monochromen Anzeigen beliebig gewählt werden kann. Die Lichtquelle darf nicht flimmern, um Überlagerungen bzw. Schwebungen mit der Ansteuerung der Anzeigeelemente bzw. Pixel zu verhindern.

Leuchtdioden sind als Lichtquellen in Relation zu ihrer Lichtstärke immer noch sehr teuer. Zur Hintergrundbeleuchtung werden sie deshalb vor allem dort eingesetzt, wo ihre Vorzüge - hoher Wirkungsgrad, lange Lebensdauer, Robustheit und kleine Abmessungen - besonders zur Geltung kommen. Ein typisches Beispiel sind Bildschirme für mobile Kleingeräte wie Mobiltelefone oder Navigationsgeräte. Mit LEDs bestückte LCD-Fernseher sind im Handel erhältlich, haben sich aber bisher (2008) nicht auf breiter Front durchsetzen können. Als kostengünstige Lichtquellen werden am häufigsten Leuchtstoffröhren (bei Grossanzeigen werden meist Kaltkathodenröhren) verwendet. Ihre UV-Strahlung wird durch Verwendung speziellen Rohrglases blockiert, um die umgebenden Kunststoffe nicht zu schädigen. Kaltkathodenröhren finden sich bei nahezu allen Laptops, Monitoren, LCD-Fernsehern sowie einigen PDAs.

Für den Einsatz als Hintergrundbeleuchtung besonders geeignet erscheinen Lichtquellen, die von vornherein Flächenstrahler sind, weil damit die Anforderungen an die Lichtführung deutlich verringert werden. Bereits seit etwa 1950 gibt es Elektrolumineszenz-Folien, die mit weniger als 1 mm Stärke extrem flach sind. Der Wirkungsgrad, die Lebensdauer und die erzielbare Leuchtdichte von Elektrolumineszenz-Folien sind aber so, dass ein Einsatz in Monitoren oder Fernsehgeräten nicht möglich ist. Als Flächenstrahler realisierbar sind weiterhin Xenon-Niederdrucklampen mit dielektrisch behinderter Entladung (z.B. Planon von OSRAM) sowie organische Leuchtdioden (OLEDs). Diese könnten in einigen Jahren kommerziell erfolgreich werden, sobald der Wirkungsgrad und die Lebensdauer den Marktanforderungen entsprechen. Glühlampen werden für Hinterleuchtungen nicht mehr benutzt.

Das von punkt- oder stabförmigen Lichtquellen ausgesandte Licht muss möglichst gleichmäßig über die Fläche der Hintergrundbeleuchtung verteilt werden. Dies bezeichnet man als Lichtführung. Bei relativ schwacher Hintergrundbeleuchtung wird das Licht meistens an den Stirnseiten eines Lichtleiters eingespeist. In der Praxis ist der Lichtleiter eine flache Platte aus einem durchsichtigen Kunststoff wie etwa Acrylglas. Diese enthält Extraktoren, die das Licht aus dem Lichtleiter auskoppeln. Die Auskopplung kann durch im Lichtleitermaterial verteilte streuende Strukturen, durch gezielte feine Oberflächenstrukturen oder durch feine, aufgedruckte Muster realisiert werden. Die inhomogene Verteilung der auskoppelnden Strukturen bewirkt, dass die gleichmäßige Ausleuchtung der Fläche auch z.B. mit nur einer stirnseitig einstrahlenden Kaltkathodenröhre erreicht wird. Zur Vergrößerung der Leuchtdichte können die Lichtquellen aber auch an zwei oder allen vier Stirnflächen angebracht werden. Eine Hintergrundbeleuchtung nach diesem Prinzip wird als "edge lit backlight" bezeichnet. - Mit zunehmender Größe der Lichtquelle (und konstantem Seitenverhältnis, z. B. 16:9) wächst die Summe der Seitenlängen nur proportional zur Länge einer Seite, die Fläche dagegen quadratisch. Da die Leistung oder der Wirkungsgrad der Lichtquellen nicht beliebig gesteigert werden können, sind die "edge lit backlight" hier prinzipiell begrenzt. Für größere Formate werden deshalb Konstruktionen eingesetzt, die von den bekannten Leuchtkästen abgeleitet sind. Die Lichtquellen befinden sich dabei in einer flachen Wanne, die das Licht in ihrem Innern diffus reflektiert und nur zur offenen Seite hin austreten lässt. Für Leuchtstofflampen werden oft speziell geformte Reflektoren und für LEDs Diffusorlinsen eingesetzt, damit trotz einer geringen Bautiefe der Hintergrundbeleuchtung das aus der Lichtwanne austretende Licht annähernd homogen ist.

Das vom Lichtleiter oder der Lichtwanne verteilte Licht hat eventuell noch eine räumliche Struktur und muss mit Hilfe eines Diffusors gleichverteilt werden, damit es einer absolut gleichmäßig weiß leuchtenden Fläche nahe kommt. Eine einfache Lösung ist eine opal streuende Platte zwischen Lichtleiter oder Lichtwanne und LC-Bildschirm. Meist setzt man jedoch Folien ein, die das Licht effizienter homogenisieren, als dies mit Opalglas möglich ist. Von der Firma 3M wurden z. B. die sogenannten Vikuiti-Folien entwickelt, die das Licht gegenüber einem opalen Diffusor um den Faktor Zwei besser ausnutzen. Diese Folien reflektieren all jenes Licht zurück zum Lichtleiter, das hinsichtlich Richtung und Polarisation für die Hinterleuchtung des LCD nicht geeignet ist. Dieses Licht wird im Lichtleiter gestreut, dabei in Richtung und Polarisation vermischt und gelangt erneut in Richtung LCD. Ähnlich einer geometrischen Reihe wiederholt sich der Vorgang und führt zu einer besseren Ausnutzung des Lichtes.

Insbesondere die Auskopplung des Lichtes aus einem lichtleitenden Material wird heute mit Lösungen zur diffusen Lichtstreuung realisiert. Sie kann durch im Lichtleitermaterial verteilte streuende Strukturen, durch gezielte feine Oberflächenstrukturen oder durch feine aufgedruckte Muster realisiert werden. Zur Lösung dieses Problems wird nach heutigem Stand der Technik also mit diffuser Lichtstreuung an rauhen Oberflächen gearbeitet oder ein flächiger Abstrahler verwendet (z.B. Leuchtstoffröhren). Diese Methoden verhindern die Möglichkeit, die Leuchtfläche durchsichtig und als homogenen Lichtabstrahler zu realisieren; Problem (E).

Dieses Problem (E) wird dadurch gelöst, dass Anstelle der Auskopplung durch Streuung, Auskopplung mittels Lumineszenz erfolgt, unter Verwendung eines iLK, da dieser durchsichtig gemacht werden kann. Mit Hilfe des hier vorgestellten iLK kommen analoge Prinzipien zum tragen, wie sie für den Lumineszenzkonzentrator (LK) gelten.

Wir haben im Verlauf von mehreren Jahren Verfahren entwickelt, die den Aufbau von lumineszierenden Materialien mit erheblichen optisch anisotropen Eigenschaften erlauben, bei denen der strahlungslose Energietransfer von Donor-Molekülen zu Akzeptoren, die dann das Licht als Lumineszenz wieder aussenden, feingesteuert werden kann, so dass ein vielfältiges Spektrum von interessanten Eigenschaften erschlossen wird. Uebersichtsartikel die auch die Entwicklung dieser Arbeiten illustrieren sind: G. Calzaferri, CHIMIA 52 (1998) 525-532; G. Calzaferri, D. Brühwiler, S. Megelski, M. Pfenniger, M. Pauchard, B. Hennessy, H. Maas, A. Devaux, U. Graf, Solid State Sciences 2 (2000) 421-447; G. Calzaferri, S. Huber, H. Maas, C. Minkowski Angew. Chem. Int. Ed. 42, 2003, 3732-3758;. G. Calzaferri, K. Lutkouskaya, Photochem. Photobiol. Sci., 2008, 7,879 - 910.

Wir haben bereits früher vorgeschlagen, dass es sich lohnen würde, die von uns entwickelten Farbstoff-Zeolith Materialien für LK einzusetzen. Siehe dazu z.B.: *Orientierte Zeolith L Kristalle auf einem Substrat,* G. Calzaferri, A. Zabala Ruiz, H. Li, S. Huber, *Oriented zeolite material and method for producing the same,* PCT/CH2006/000394; priority US 60/698,480 and CH 1266/05. Nanochannel Materials for Quantum Solar Energy Conversion Devices, D. Brühwiler, L.-Q. Dieu, G. Calzaferri, CHIMIA, 61, 2007, 820-822. Dye modified nanochannel materials for photoelectronic and optical devices, G. Calzaferri, H. Li, D. Brühwiler, Chem. Eur. J., 2008, 14, 7442 - 4749. In diesen Arbeiten werden gewisse Aspekte der neuen Materialien diskutiert, die für die Herstellung von LK nützlich sein könnten.

Wir haben insbesondere gefunden, dass es möglich ist, Zeolithkristalle derart in ein Polymer einzubinden, dass die durch die Zeolithkristalle verursachte Lichtstreuung im relevanten langwelligeren Bereich vollständig unterdrückt werden kann. Siehe dazu: Transparent Zeolite-Polymer Hybrid Materials with Tunable Properties, S. Suárez, A. Devaux, J. Bañnuelos, O. Bossart, A. Kunzmann, G. Calzaferri, Adv. Funct. Mater. 17, 2007, 2298-2306; *Transparent Zeolite-Polymer Hybrid Material with Tunable Properties,* G. Calzaferri, S. Suarez, A. Devaux, A. Kunzmann, H. J. Metz, PCT European Patent application EP1873202.

Wichtige Begriffe wie Zeolith L, Antenne, organisierte Farbstoff-Zeolith Materialien usw. sind in der in deutscher Sprache erschienenen Arbeit: Photon-Harvesting Host-Guest Antenna Materials (Wirt-Gast Antennenmaterialien) Gion Calzaferri, Stefan Huber, Huub Maas, Claudia Minkowski, Angew. Chem. 115, 2003, 3860-3888; Angel. Chem. Int. Ed. 42, 2003, 3732-3758 erklärt. In Figur 2 zeigen wir einen zylindrischen Zeolithnanokristall mit organisierten Farbstoffmolekülen, die als Donoren (graue Rechtecke) und Akzeptoren (schwarze Rechtecke) fungieren. Im linken Teil der Abbildung befinden sich die Donoren in den mittleren Bereichen und die Akzeptoren an den beiden Enden der Kanäle, im rechten Teil sind die Donoren an den Enden und die Akzeptoren im Mittelteil platziert. Die aus supramolekular geordneten und dergestalt organisierten Farbstoffmolekülen in Zeolithen sind so aufgebaut, dass dadurch eine Antennenfunktion resultiert, welche Lumineszenz-Zentren als Antennen bezeichnet werden. Dadurch wird eine wesentliche Verschiebung der Lumineszenz nach grösseren Wellenlängen erreicht. Die Vergrösserung zeigt Einzelheiten eines Kanals mit einem Farbstoffmolekül, dessen elektronisches Übergangsmoment (Doppelpfeil) bei grossen Molekülen parallel zur Kanalachse liegt und bei kleineren Molekülen ausgelenkt ist. Der Durchmesser einer Kanalöffnung von Zeolith L beträgt 0.71 nm, bei einem grössten Kanaldurchmesser von 1.26 nm. Der Abstand von der Mitte eines Kanals zur Mitte eines Nachbarkanals beträgt 1.84 nm.

### Darstellung der Erfindung

Die Idee der vorliegenden Arbeit ist im Rahmen des KTI Projektes 9231.2 PFNM-NM (Entwicklung effizienter LK basierend auf anorganisch-organischen Nanomaterialien zur Verwendung in der Solarenergiegewinnung) entstanden. Aufgabe der Erfindung ist es die Einzellösungen der Probleme A) bis D) neu und integral in einer Vorrichtung zu realisieren. Dadurch wird ein funktionstüchtiger und hocheffizienter LK ermöglich. Unter Einbezug der Problemlösung E), entsteht sogar ein iLK; s.a. Patentansprüche 1 und 4. Demnach besteht die Erfindung darin, die Lösungen der oben genannten Probleme (A) bis (E) von LK und iLK durch raffinierte und rigorose Ausnutzung aller zur Zeit bekannten Forschungsergebnisse so zu nutzen, dass LK und iLK für kommerzielle Nutzung interessant werden. Es ergeben sich neue Verwendungen, die in einigen Beispielen beschrieben sind; s.a. Patentansprüche 5 bis 13.

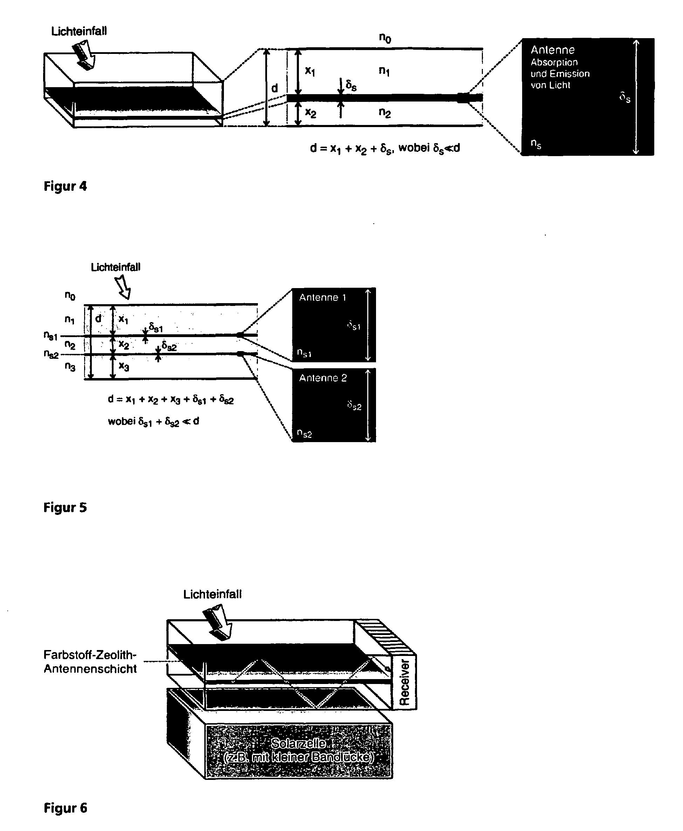

Der lichtabsorbierende und lichttransportierende Teil besteht im Wesentlichen aus drei Bereichen und ist schematisch in den Figuren 1, 4 und 5 dargestellt. (B1) Einem durchsichtigen Glas oder Polymer mit Brechungsindex n₁ und Schicht- oder Plattendicke x₁, auf welches das Licht fällt. (B2) Einem lichtabsorbierenden und lichtemittierenden Teil, den wir als Antenne bezeichnen und dessen Funktionsweise anhand von Figur 2 erläutert wird, bestehend aus einer oder mehreren in der Regel gerichteten Farbstoff-Zeolith-Lagen, siehe Figur 3, die- in ein transparentes Polymer eingebettet sind. Die Dicke der einzelnen Zeolith-Lagen liegt typischerweise im Bereich zwischen 100 nm und 2000 nm. Die Länge und Dicke der verwendeten Zeolithkristalle liegt ebenfalls in diesem Grössenbereich wobei scheibenförmige Kristalle häufig von Vorteil sind. Die einzelnen Lagen können sehr dicht gepackt sein oder sie können über dünne Zwischenlagen eines durchsichtigen Materials getrennt sein. Der Brechungsindex der Zwischenlagen und des Polymers, in welches die Zeolith-Lagen eingebettet sind, wird so gewählt, dass optimale Eigenschaften resultieren. (B3) Als nächstes folgt ein durchsichtiges Polymer oder Glas mit Brechungsindex n₂ und Schicht- oder Plattendicke x₂. Während die Bereiche (B1) und (B3) üblichen Anforderungen entsprechen, typischerweise einige mm dick sind und sich auch aus z.B. zwei Schichten oder Platten aufbauen lassen, wie etwa einem Grundkörper und einer oberflächenbehandelten Schicht oder Platte oder einem Glas- und einem Polymer-Teil, ist der Bereich (B2) komplexer aufgebaut und stellt das eigentliche Kernstück dar; siehe Figur 4 und 5. Figur 4 zeigt einen Lumineszenzkonzentrator mit einer Farbstoff-Zeolith-Antennen-Lage. Diese Antennen-Lage besteht aus einer oder mehreren Lagen ausgerichteter oder ungeordneter Farbstoff-Zeolithkristalle, welche in einem dünnen Polymerfilm eingebettet, bzw. mit einem dünnen Polymerfilm überschichtet sind. Eine der beiden unmittelbar angrenzenden Schichten oder Platten, mit Dicke x₁ bzw. x₂, kann bei Bedarf weggelassen werden. Die Brechungsindices der angrenzenden Schichten oder Platten sind n₁ und n₂; nₛ ist der Brechungsindex der Antennen-Lage und n₀ ist der Brechungsindex der Umgebung (typischerweise Luft). δₛ ist die Dicke der Antennen-Lage. Figur 5 zeigt eine zweidimensionale Ansicht eines LK mit zwei Farbstoff-Zeolith-Antennen-Lagen. Die Zahl der Antennen-Lagen kann beliebig erweitert werden, wobei die Summe der Dicken der Antennen-Lagen wesentlich kleiner ist als d. Die Antennen-Lagen können verschieden aufgebaut sein, z.B. unterschiedliche Farbstoff-Zeolithkristalle enthalten. Die Bezeichnung von Lagendicken und Brechungsindices ist analog zu Figur 4.

Dieser Aufbau löst nicht nur die unter "Stand der Technik" dargelegten Probleme (A) bis (C), sondern hat einen erheblichen Einfluss auf die Stabilität der Chromophoren, weil die Donormoleküle die aufgenommene Energie via Nahfeldwechselwirkung im Subpicosekundenbereich weitergeben, so dass kaum Zeit für eine Reaktion im elektronisch angeregten Zustand bleibt, und weil die räumliche Begrenzung durch die Nanoröhren einen Käfigeffekt zur Folge hat und damit sowohl intra- als auch intermolekulare Bewegungen, die zu Reaktionen führen könnten, verunmöglichen oder zumindest erheblich behindern. Insbesondere können auch kleine reaktive Moleküle wie etwa Sauerstoff quantitativ ausgeschlossen werden.

Der Einbau der Farbstoffe in die Zeolith L Kristalle erfolgt im Falle von neutralen Farbstoffmolekülen aus der Gasphase, im Falle von kationischen Farbstoffen aus einem geeigneten Lösungsmittel. Farbstoffe, welche an der äusseren Zeolithkristalloberfläche adsorbiert sind, werden nachträglich durch Waschen mit einem Lösungsmittel entfernt. Der Einbau unterschiedlicher Farbstoffe kann sequentiell oder parallel erfolgen. Bei sequentiellem Einbau resultieren definierte Farbstoffdomänen, wobei die Platzierung der Akzeptormoleküle in der Mitte der Zeolithkanäle aufgrund der besseren Abschirmung gegen externe reaktive Spezies vorteilhaft sein kann. Für andere Verwendungszwecke oder für gewisse Chromophoren ergibt eine Platzierung an den Enden der Kanäle optimale Eigenschaften. Der parallele Einbau verschiedener Farbstoffe führt zu einer Durchmischung im Kristall. Zur Eliminierung der Selbstabsorption wird, unabhängig vom Einbauverfahren, ein grosses Donor/Akzeptorverhältnis gewählt, das in der Regel grösser oder erheblich grösser als 10:1 1 ist.

Das Auftragen der farbstoffbeladenen Zeolithkristalle auf ein Substrat (z.B. Glas) und die Beschichtung mit einem durchsichtigen Polymer kann zum Beispiel wie folgt realisiert werden: (1) Durch Herstellung einer homogenen Mischung von Polymer und Zeolithkristallen in einem geeigneten Lösungsmittel. Die Mischung wird durch Aufstreichen (z.B. Doctor Blading) oder Spin Coating auf das Substrat gebracht. Nach dem Verdampfen des Lösungsmittels entsteht eine robuste Zeolith-Polymer-Lage definierter Dicke. (2) Durch Herstellung einer oder mehrerer Zeolith-Lagen (gerichtet oder ungeordnet) auf dem Substrat und anschliessender Fixierung mit wenig Polymer. Nach dem Trocknen wird die restliche Polymer-Lage durch Aufstreichen (z.B. Doctor Blading) oder Spin Coating aufgetragen. In andern Fällen kann die Methode wie sie in Figur 3 illustriert ist, vorteilhaft sein; vgl. dazu: Organizing supramolecular functional dye-zeolite crystals, A. Zabala Ruiz, H. Li, G. Calzaferri, Angew. Chem. Int. Ed., 2006, 45, 5282-5287; Fabrication of oriented zeolite L monolayers employing luminescent perylenediimide-bridged Si(OEt)3 precursor as the covalent linker, H. Li, Y. Wang, W. Zhang, B. Liu, G. Calzaferri, Chem. Commun. 2007, 2853-2854; Fabrication of oriented zeolite L monolayer via covalent molecular linkers, Y. Wang, H. Li, B. Liu, Q. Gan, Q. Dong, G. Calzaferri, Z. Sun, J. Solid State Chemistry, 2008, 181, 2469-2472. Die Kristalle können auch ähnlich einer Nematischen Phase ausgerichtet werden, wobei eine erheblich dichtere Packung als die in Figur 3 (rechts) abgebildete möglich ist. Figur 3 zeigt links eine elektronenmikroskopische und rechts eine fluoreszenzmikroskopische Aufnahme und stammt aus: Organisation and Solubilisation of Zeolite L Crystals, Olivia Bossart and Gion Calzaferri, Chimia 2006, 60, 179-181.

In jedem Fall kann bei Bedarf ein Abdeckmaterial (z.B. eine Glasplatte oder ein Polymerfilm) auf die Zeolith-Polymer-Lage gebracht werden. Die relative Position der lumineszierenden Zeolith-Polymer-Lage wird dabei durch die Dicke von Substrat und Abdeckmaterial kontrolliert. Das Abdeckmaterial kann durch Wiederholung der oben beschriebenen Prozedur mit einer weiteren Farbstoff-Zeolith-Lage bedeckt werden, wodurch sich ein Aufbau wie in Figur 5 gezeigt realisieren lässt. Das Aufbringen weiterer Farbstoff-Zeolith-Lagen und Zwischenlagen ist beliebig wiederholbar, wodurch sich definierte, durch Zwischenlagen getrennte Stapel von Antennen-Lagen lassen.

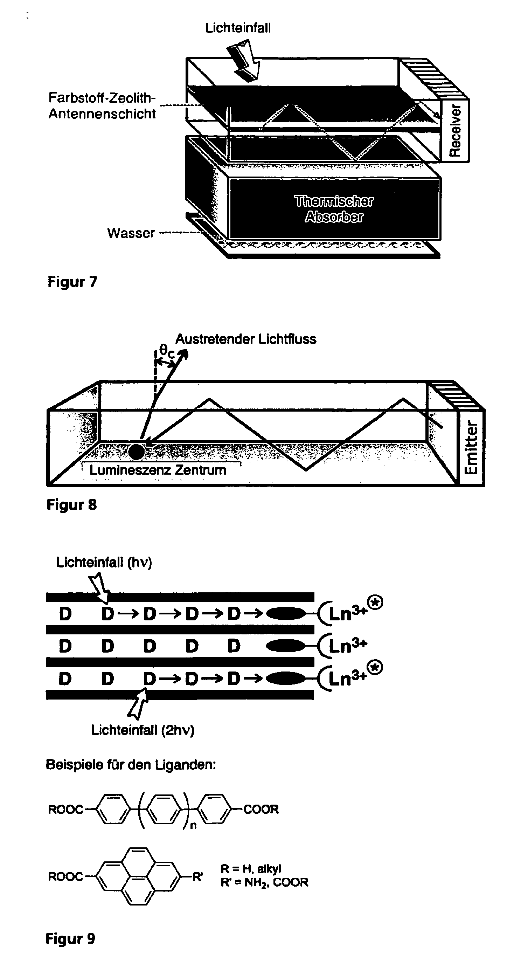

Der Aufbau des iLK bzw. eines Lumineszenzdispergators (LD) (Figur 8) ist analog wie jener der LK (Figur 1). Anstelle des Receivers beim LK wird ein Emitter als Anregungslicht (z.B. UV) Der Aufbau des iLK bzw. eines Lumineszenzdispergators (LD) (Figur 8) ist analog wie jener der LK (Figur 1). Anstelle des Receivers beim LK wird ein Emitter als Anregungslicht (z.B. UV) angebracht. Durch Totalreflexion wird das Licht durch den Lichtleiter transportiert. Beim Auftreffen auf ein Lumineszenz-Zentrum, bestehend aus einem Farbstoff-Zeolithkristall, wird das Licht absorbiert und wieder emittiert. Durch gerichtete Anordnung der Lumineszenz-Zentren (Farbstoff-Zeolithkristalle) wird der Emissionswinkel so gewählt, dass das Photon den Lichtleiter verlässt (vgl. Fig. 1 Austretender Lichtfluss). Für in den Körper eintretende Wellenlängen, welche nicht durch die Lumineszenz-Zentren (Farbstoff-Zeolithkristalle) absorbiert werden, ist der Körper transparent. Durch die Konzentrationsverteilung in Abhängigkeit von der Emitterdistanz und/oder durch die Reflexion an den Körperseiten kann eine gleichmässige Flächenemission aus dem Körper hinaus realisiert werden (der letzte Schritt gleicht teilweise den Leuchtkästen mit diffuser Reflexion im Kasteninnern und einer Öffnung, durch welche das Licht diffus aus dem Kasten abgestrahlt wird). Der Wellenlängenbereich in dem die verwendeteten Farbstoff-Zeolith Nanokristalle emittieren, kann durch Anpassung der Donor/Akzeptor Kombination von schmalbandiger Emission bis zu weissem Licht gewählt werden (vgl. dazu G. Calzaferri, S. Huber, H. Maas, C. Minkowski Angew. Chem. Int. Ed. 42, 2003, 3732-3758; G. Calzaferri, K. Lutkouskaya, Photochem. Photobiol. Sci., 2008, 7, 879 - 910).

### Kurze Beschreibung der Figuren

Figur 1. Skizze eines konventionellen Lumineszenzkonzentrators (LK).
Figur 2. Lumineszenz-Zentren: Zylindrische Zeolithnanokristalle mit organisierten Farbstoffmolekülen, die als Donoren (graue Rechtecke) und Akzeptoren (schwarze Rechtecke) fungieren.
Figur 3. Orientierte Zeolith-Lage. Links: Elektronenmikroskopisches Bild von zylinder-förmigen Zeolith L Kristallen, die auf einer Glasunterlage stehen. Rechts: Die Kristalle können auch ähnlich einer Nematischen Phase ausgerichtet werden (elektronenmikroskopisches und fluoreszenzmikroskopisches Bild).
Figur 4. Lumineszenzkonzentrator mit einer Farbstoff-Zeolith-Antennenschicht.
Figur 5. Zweidimensionale Ansicht eines LK mit zwei Farbstoff Zeolith-Antennenschichten.
Figur 6. Lumineszenzkonzentrator-Tandemsolarzellenapparatur.
Figur 7. Kombination Lumineszenzkonzentrator-Solarzellenapparatur mit Warmwasseraufbereitung.
Figur 8. Umgekehrte Nutzung von LK. Anstelle des Receivers wird ein Emitter an den LK angebracht und so mutiert der LK zum iLK. Der Emitter strahlt Anregungslicht in den Lumineszenzdispergator. Das Licht wird durch den Farbstoff-Zeolith (Lumineszenz-Zentrum) absorbiert und als Lumineszenz wieder abgestrahlt. Durch geeignete Anordnung der Lumineszenz-Zentren kann die Lumineszenzemission so gerichtet werden, dass das Licht den Lichtleiter verlässt.
Figur 9. LK Unter Verwendung von Seltene Erden-Emitter-Antenne. Die Fixierung der Ln³⁺ erfolgt gemäss: *SOMC@PMS.* Surface Organometallic Chemistry at Periodic Mesoporous Silica, R. Anwander, Chem. Mater. 2001, 13, 4419-4438.
Figur 10. Pyren als Donor und einige mögliche Liganden, als Beispiele (von links nach rechts: pyrene, 2-carboxy-7-amino pyrene, 1-pyreneamine, 1-pyrenecarboxylic acid).
Figur 11. Diese Darstellung zeigt, wie anstelle eines Objektes mit Hilfe einer Fläche mit gerichteter Emission dem Betrachter (Augenlinse) ein Bild auf die Netzhaut projiziert werden kann. Einzelne Bildelemente auf der Fläche emittieren Photonen im räumlichen Abstrahlwinkel Alpha. Der Abstrahlwinkel des einzelnen Bildpunktes bestimmt, welches Pixel des zu projizierenden Bildes von diesem Bildpunkt abgestrahlt werden muss.
Figur 12. Beispiele von kationischen Farbstoffen, die in Zeolith L eingebaut wurden und die für die hier beschriebene Verwendung in Frage kommen.
Figur 13. Beispiele von neutralen Farbstoffen, die in Zeolith L eingebaut wurden und die für die hier beschriebene Verwendung in Frage kommen.

### Wege zur Ausführung der Erfindung

### 1. Aufbau eines LK

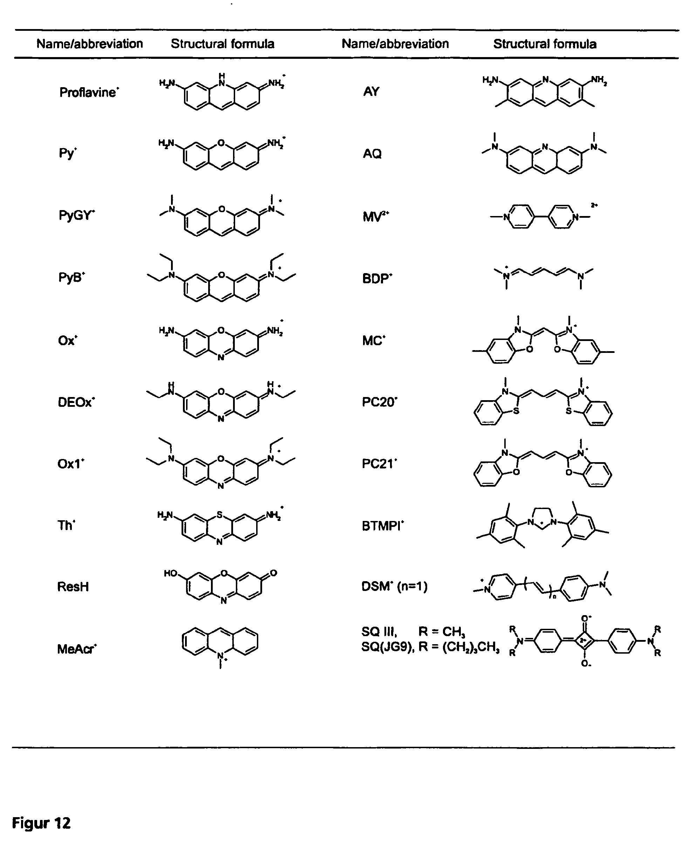

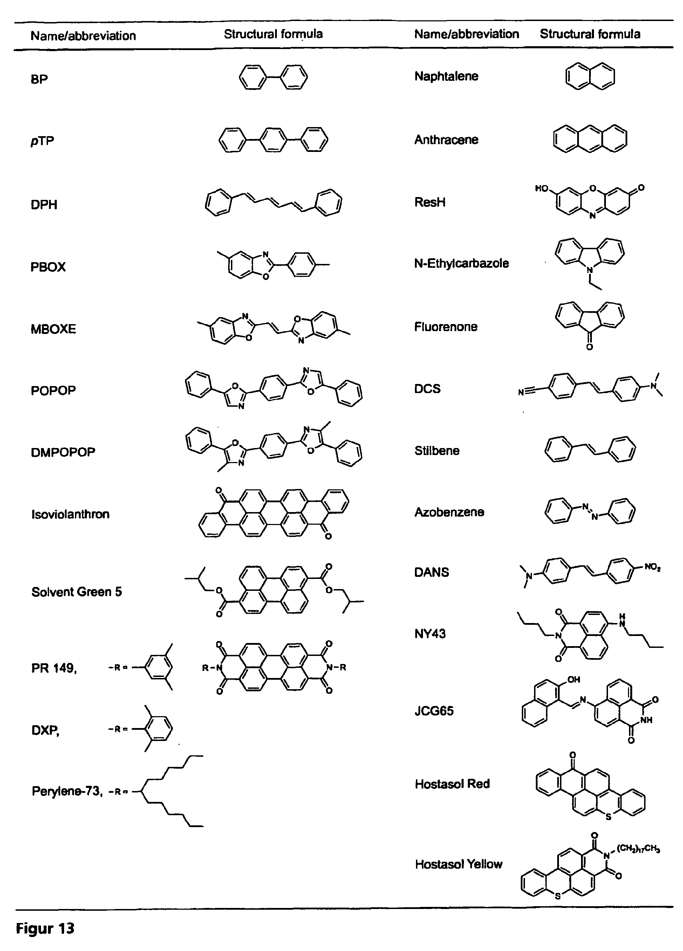

Der Einbau der Farbstoffe in die Zeolith L Kristalle erfolgt im Falle von neutralen Farbstoffmolekülen in der Regel aus der Gasphase bei erhöhter Temperatur, im Falle von kationischen Farbstoffen aus einem geeigneten Lösungsmittel. Farbstoffe welche an der äusseren Zeolithkristalloberfläche adsorbiert sind, werden nachträglich durch Waschen mit einem Lösungsmittel entfernt. Der Einbau unterschiedlicher Farbstoffe kann sequentiell oder parallel erfolgen. Bei sequentiellem Einbau resultieren definierte Farbstoffdomänen, wobei die Platzierung der Akzeptormoleküle in der Mitte der Zeolithkanäle aufgrund der besseren Abschirmung gegen externe reaktive Spezies vorteilhaft sein kann. Der parallele Einbau verschiedener Farbstoffe führt zu einer Durchmischung im Kristall. Zur Eliminierung der Selbstabsorption wird ein grosses Donor/Akzeptorverhältnis gewählt (> 10:1). Beispiele von Farbstoffen, die auf diese Weise erfolgreich in die Kanäle von Zeolith L eingebaut wurden, sind in den Figuren 12 und 13 zusammengestellt.

Das Auftragen der farbstoffbeladenen Zeolithkristalle auf ein Substrat (z.B. Glas) und die Beschichtung mit einem durchsichtigen Polymer (z.B. PMMA, CR39, PVA) kann zum Beispiel wie folgt realisiert werden: (1) Durch Herstellung einer homogenen Mischung von Polymer und Zeolithkristallen in einem geeigneten Lösungsmittel. Die Mischung wird durch Aufstreichen (z.B. Doctor Blading) oder Spin Coating auf das Substrat gebracht. Nach dem Verdampfen des Lösungsmittels entsteht eine robuste Zeolith-Polymer-Schicht definierter Dicke. (2) Durch Herstellung einer oder mehrerer Zeolith-Lagen (gerichtet oder ungeordnet) auf dem Substrat und anschliessender Fixierung mit wenig Polymer. Nach dem Trocknen wird die restliche Polymerschicht durch Aufstreichen (z.B. Doctor Blading) oder Spin Coating aufgetragen. in andern Fällen kann die Methode, wie sie in Figur 3 illustriert ist, vorteilhaft sein; vgl. dazu: Organizing supramolecular functional dye-zeolite crystals, A. Zabala Ruiz, H. Li, G. Calzaferri, Angew. Chem. Int. Ed., 2006, 45, 5282-5287; *Fabrication of oriented zeolite L monolayers employing luminescent perylenediimide-bridged Si(OEt)₃ precursor as the covalent linker,* H. Li, Y. Wang, W. Zhang, B. Liu, G. Calzaferri, Chem. Commun. 2007, 2853-2854; Fabrication of oriented zeolite L monolayer via covalent molecular linkers, Y. Wang, H. Li, B. Liu, Q. Gan, Q. Dong, G. Calzaferri, Z. Sun, J. Solid State Chemistry, 2008, in press. Die Kristalle können auch ähnlich einer Nematischen Phase ausgerichtet werden, wobei eine erheblich dichtere Packung als die in Figur 3 (rechts) abgebildete möglich ist. Figur 3 zeigt links eine elektronenmikroskopische und rechts eine fluoreszenzmikroskopische Aufnahme und stammt aus: Organisation and Solubilisation of Zeolite L Crystals, Olivia Bossart and Gion Calzaferri, Chimia 2006, 60, 179-181.

In jedem Fall kann bei Bedarf ein Abdeckmaterial (z.B. eine Glasplatte) auf die Zeolith-Polymerschicht gebracht werden. Die relative Position der lumineszierenden Zeolith-Polymerschicht wird dabei durch die Dicke von Substrat und Abdeckmaterial kontrolliert. Das Abdeckmaterial kann durch Wiederholung der oben beschriebenen Prozedur mit einer weiteren Farbstoff-Zeolithschicht bedeckt werden, wodurch sich ein Aufbau wie in Figur 5 gezeigt realisieren lässt. Das Aufbringen weiterer Farbstoff-Zeolithschichten und Zwischenschichten ist beliebig wiederholbar, wodurch sich definierte, durch Zwischenschichten getrennte Stapel von Antennenschichten herstellen lassen.

### 2. Herstellung eines LK unter Ausnutzung von Oberflächen-verstärkter Plasmonresonanz

Die kontrollierte Verstärkung der Lumineszenzeigenschaften von Molekülen durch Metall-Nanostrukturen (Dünnschichten oder Partikel) ist seit einigen Jahren bekannt (K. Aslan, I. Gryczynski, J. Malicka, E. Matveeva, J. R. Lakowicz, C. D. Geddes, Curr. Opin. Biotechnol. 16, 2005, 55). Untersuchungen zu potentiellen Verwendungen konzentrierten sich bislang auf die Bereiche Biotechnologie und LEDs. Zusammen mit den hier beschriebenen neuen LK, ergeben sich eine Reihe von innovativen Möglichkeiten zur Verwendung der Metallverstärkten Lumineszenz: Scheibenförmige Zeolith L Kristalle werden zunächst mit Donormolekülen beladen. Die im Unterschuss vorhandenen Akzeptormoleküle werden nachträglich eingebaut und befinden sich somit an den Enden der Zeolithkanäle. Das Substrat besteht aus einem konventionellen Trägermaterial (z.B. Glas), welches mit einem dünnen Metallfilm beschichtet wird. Danach werden die scheibenförmigen, farbstoffbeladenen Zeolithkristalle so aufgebracht, dass jeder direkte Kontakt zwischen dem metallischen Substrat und den Farbstoffen vermieden wird. Dies geschieht nach dem oben beschriebenen Verfahren unter Bildung einer ausgerichteten Lage, was zur Folge hat, dass zwischen Metallfilm und Akzeptormolekülen Abstände im Bereich weniger Nanometer resultieren. Bei solchen Abständen (ein direkter Kontakt zwischen Farbstoff und Metallfilm ist nicht erforderlich und muss in der Regel vermieden werden) kann die Emission der Farbstoffe durch Anregung von Oberflächenplasmonen im Metallfilm und der damit verbundenen Vergrösserung des elektromagnetischen Feldes wesentlich verstärkt werden. Bezüglich der Effizienz und Stabilität eines LK kann dieser Aufbau folgende Vorteile bringen: (i) Verkürzung der Lebensdauer des angeregten Zustands der Akzeptormoleküle und somit Erhöhung der Photostabilität. (ii) Vergrösserung der Lumineszenzquantenausbeute der Akzeptormoleküle und somit höhere Effizienz des LK. Zusätzlich ergibt sich die Möglichkeit Akzeptormoleküle zu verwenden, welche zwar eine geringe Quantenausbeute besitzen, dafür aber andere vorteilhafte Eigenschaften (Stabilität, Preis) aufweisen. Der gleiche Effekt führt zu einer verstärkten Absorption, allerdings nur im Bereich einiger weniger nm vom der Metalloberfläche entfernt.

### 3. Aufbau eines LK unter Verwendung von Seltene Erden Chromophoren als Emitter

Es ist gut bekannt, dass seltene Erden Ln³⁺ in verschiedener Form in die Kanäle von Zeolith L eingebaut werden können und zu interessanten Lumineszenzeigenschaften führen *(*Luminescence properties of nanozeolite L grafted with terbium organic complex, Y. Wang, H. Li, W. Zhang, B. Liu, Materials Letters, 2008, 62, 3167-3170; Highly Luminescent Host-Guest Systems Based on Zeolite L and Lanthanide Complexes, Y. Wang, Z. Guo, H. Li, J. Rare Earth, 2007, 25, 283-285; Sensitized near infrared emission from lanthanide-exchanged zeolites, A. Monguzzi, G. Macchi, F. Meinardi, R. Tubino, M. Burger, G. Calzaferri, Appl. Phys. Lett. 92, 2008, 123301/1-123301/3)

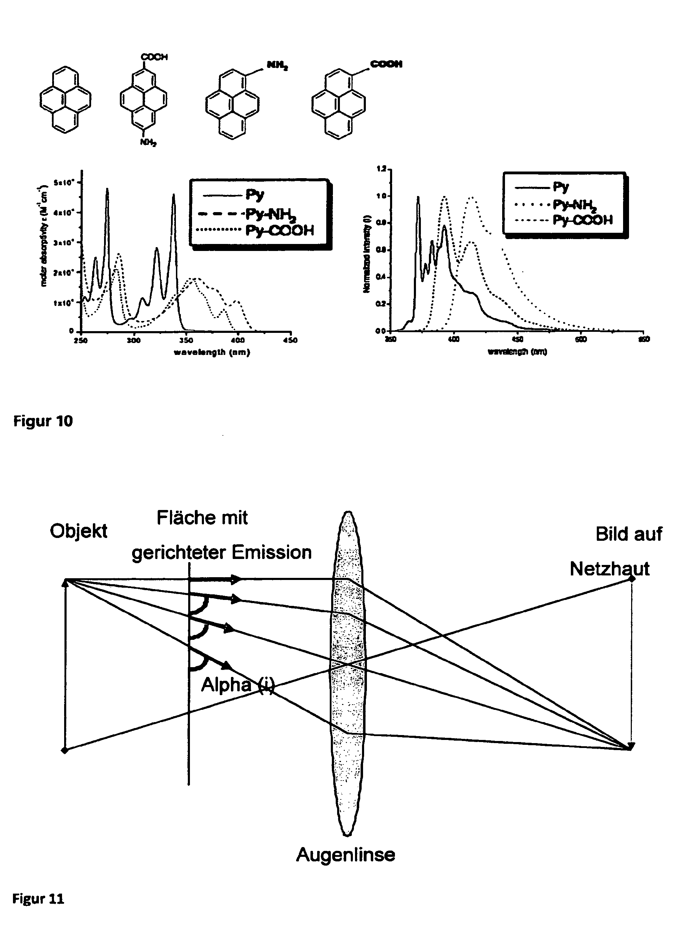

Hier verwenden wir eine neuartige Kombination eines Antennen-Hybridmaterials, bei dem ein seltenes Erd-lon als Emitter dient. Die Besonderheit dieser Kombination besteht darin, dass die Seltenen Erden Verbindungen - die vergleichsweise nur geringe Lichtabsorption aufweisen, auch wenn sie mit sogenannten Antennenliganden ausgestattet sind - über unsere Antennensysteme, die sehr hohe Lichtabsorption haben, angeregt werden können, ohne ihre Fähigkeit schmalbandig zu emittieren, zu verlieren, wie in Figur 9 und 10 erklärt. Dabei können als Antennenabsorber auch Moleküle verwendet werden, die ausgesprochene nichtlinear optische (NLO) Eigenschaften haben, so dass mit Zweiphotonenanregung gearbeitet werden kann. Zweiphotonenanregung-Antennen können für solare Verwendungen hochinteressant sein, aber auch für Mikroskopie bis hin zur Diagnostik; vgl. dazu Cell-Permeant Cytoplasmic Blue Fluorophores Optimized for In Vivo Two-Photon Microscopy With Low-Power Excitation, A. Hayek, A. Grichine, T. Huault, C. Ricard, F. Bolze, B. Van Der Sanden, J.-C. Vial, Y. Mely, A. Duperray, P. L. Baldeck, J.-F. Nicoud, Microscopy Research and Technique 70, 2007, 880-885. Wir verwenden u.a. Pyren Derivate, weil diese sehr gute Voraussetzungen für eine erfolgreiche Sensibilisierung von Eu³⁺ mitbringen. Sie weisen im nahen UV hohe Absorption auf, haben grosse Lumineszenz-Ausbeuten und Intersystem-Crossing; vgl dazu: A. R. Horrocks, F. Wilkinson, Proc. Rpy. Soc. A. 306, 1968, 257-273. Die Koordinationseigenschaften von Pyrenen zu den Lanthanidionen können mit Hilfe einfacher Synthese (Anbringen von Säure-, Ester-, Amid-, Amino-Gruppen und andere) gut angepasst werden. Substituenten in 2-Position zeichnen sich dadurch aus, dass die Liganden besser in die Zeolith L Kanäle passen. Eu³⁺-Pyren Komplexe können somit auch als Zapfenmoleküle dienen, die vergleichsweise sehr schmalbandige Emission aufweisen. In einer Donor-Akzeptor Kaskade, wie sie in Figur 9 dargestellt ist, wird ein Donor-Pyren-Molekül (D) durch Lichtabsorption elektronisch angeregt. Es überträgt dann seine Anregungsenergie strahlungslos via Nahfeldwechselwirkung an Nachbarmoleküle, bis diese auf einen an Eu³⁺ koordinierten Pyrenliganden trifft. Von hier aus wird dann ein emittierender Zustand des Eu³⁺ besetzt, der etwas später ein langwelliges Photon aussendet. Die zugehörige Ligandsynthese und Koordinationschemie ist gut bekannt; vgl. dazu D. M. Connor, S. D. Allen, D. M. Collard, C. L. Liotta, D. A. Schiraldi, J. Org. Chem. 1999, 64, 6888-6890; A. Musa, B. Sridharan, H. Lee, D. Lewiss Mattern, J. Org. Chem. 1996, 61, 5481-5484; C. Yao, H.-B. Kraatz, R. P. Steer, Photochem. Photobiol. Sci. 2005, 4, 191-199. Die Absorptions- und Lumineszenz-Spektren von Py, Py-NH₂ und Py-COOH sind in Figur 10 abgebildet. Daraus ist zu entnehmen, dass Py sehr gut als Donor sowohl für Py-NH₂ als auch für Py-COOH dienen kann. Eine Beladung von Zeolith L mit nachfolgendem Anbringen von Eu³⁺-Pyren Komplexen und Herstellung von LK basierend auf diesen Antennen, führt zu LK mit anwendungstechnisch besonders interessanten spektralen Eigenschaften. Die Eigenabsorption wird hier derart gering, dass sie völlig vernachlässigt werden kann.

### 4. Die für den Aufbau von LK beschriebenen Prinzipien, Wege und Vorschriften gelten auch für die iLK.

### Gewerbliche Verwertbarkeit

### 1. LK zum Einfangen und Aufkonzentrieren von Sonnenlicht

Die Verwendung der LK sind aus der Literatur gut bekannt. Bezüglich der Prinzipien bei herkömmlicher Verwendung besteht zunächst kein Unterschied zwischen dem hier besprochenen LK und früher beschriebenen Varianten. Der zentrale Unterschied besteht jedoch darin, dass die unter "Stand der Technik" beschriebenen Probleme der bisher bekannten LK gelöst oder zumindest ausreichend gut vermindert sind, so dass sie für diese Verwendung jetzt auch realisiert werden können. Diese LK führen aufgrund ihres neuartigen Aufbaus und den damit verbundenen vorteilhaften optischen Eigenschaften zu einem erheblich besseren Preis/Leistungsverhältnis von gebäudeintegrierten photovoltaischen Anlagen und zum Einfangen und nachfolgenden Transport von Licht zum Beispiel in einer Glasfiber.

### 2. LK für Tandemsolarzelle

Das Prinzip besteht darin, dass Licht im Bereich nahes UV bis zu einer Grenzwellenlänge, die zum Beispiel 600 nm betragen kann, via LK auf eine "large band gap" Solarzelle geführt wird und dass eine "small band gap" Solarzelle auf der Rückseite des LK den langwelligen Teil des Lichtes auffängt. Damit kann eine Tandemsolarzelle gebaut werden, die kein "current matching" verlangt und bei der keine komplexen Schichten notwendig sind, siehe Figur 6. Diese Tandem-Anordnung erlaubt einen maximalen thermodynamischen Wirkungsgrad von etwas mehr als 43 % gegenüber maximal 29 % einer "single band gap" Photovoltaik Zelle; siehe dazu Peter Würfel, Physics of Solar Cells, Wiley-VCH, Weinheim, 2005

### 3. Integration Photovoltaik-Warmwasser

Eine andere Verwendungsmöglichkeit, die sich mit partiellen LKs eröffnen, ist die Integration von Photovoltaik in eine Warmwasseraufbereitungs-Vorrichtung. Das ist eine im Prinzip wohlbekannte Idee. Sie besteht darin, den langwelligen Teil der einfallenden Sonnenstrahlung zur Warmwasseraufbereitung zu nutzen und den kürzerwelligen Teil dazu, eine Photovoltaikzelle zu betreiben. Das hat energetisch grosse Vorteile und kann (in heissen Ländern) auch dazu beitragen, dass die Zellen nicht zu heiss werden (z.B. durch eine 60 °C Begrenzung). Durch Verwendung der hier beschriebenen neuartigen LK Vorrichtungen ist es möglich, den Solarzellenteil und den Warmwasserteil physikalisch völlig zu entkoppeln, wie in Figur 7 skizziert, und damit die Probleme zu lösen, die eine Folge der gemeinsamen grossen Fläche beider Wandler (thermisch und elektrisch) sind und die bei konventionellen Systemen zu kaum überwindbaren Hürden bei der praktischen Verwendung führen. Der LK ist in weiten Bereichen transparent für infrarot Strahlung, insbesondere im nahen IR.

### 4. Invertierter LK

Der Begriff *Lumineszenzkonzentrator* mag für diese "invertierte Vorrichtung" eigenartig erscheinen. Wegen der Analogie des physikalischen Vorgangs wollen wir diesen Namen trotzdem verwenden und als iLK abkürzen. Ein iLK ist so aufgebaut, dass an einer oder an mehreren Stellen seitlich Licht eingespeist wird, zum Beispiel mit Hilfe einer LED. Das Licht wird dann von Farbstoff-Zeolithantennen absorbiert und analog wie beim LK innerhalb des Antennensystems weitergeleitet bis es auf einen Bereich stösst, bei dem es von einem zweiten Typ Antennenkristallen absorbiert wird, die so ausgerichtet sind, dass das Licht nicht mehr intern reflektiert wird, sondern aus der Schicht austritt. Damit kann eine Glas- oder eine Kunststoff-Fläche partiell dunkel und partiell als diffuser Emitter erscheinen. Verwendungsbereiche für solche iLK sind vielfältig, und gehen von Signalanlagen, über Leuchtschriften, über Raumleuchten, flächige/diffuse Lichtquellen und Hindergrundbeleuchtung.

Eine Verwendung besteht in der Möglichkeit, einen Bildschirm via einen Zwei-Photonenemissionsprozess zu realisieren. Durch Beladung der Zeolithe mit einem 2 Photonenemissionssystem wird durch orthogonale Einstrahlung mit den beiden Anregungswellenlängen ein einzelnes oder mehrere Pixel zur Emission angeregt. Durch die Einstrahlungs-intensität der Anregungsquellen kann die Helligkeit der einzelnen Pixels reguliert werden. Durch geeignete Emissionswellenlängen wird die Pixelfarbe eingestellt. Anstelle einer diffusen Abstrahlung kann auch eine gerichtete Abstrahlung mit begrenztem Abstrahlöffnungswinkel eingestellt werden, um die Abstrahlintensität in der gewünschten Richtung zu erhöhen.

### 5. LK unter Ausnutzung von Oberflächen-verstärkter Plasmonresonanz

Das Phänomen der Oberflächen-verstärkten Plasmonresonanz (K. Aslan, I. Gryczynski, J. Malicka, E. Matveeva, J. R. Lakowicz, C. D. Geddes, Curr. Opin. Biotechnol. 16, 2005, 55) kann in Verbindung mit dem in Figur 4 gezeigten Aufbau in idealer Weise zur Optimierung der Lumineszenzeigenschaften der Farbstoffe eingesetzt werden. Eine an die Antennenschicht angrenzende dünne Metallschicht führt zu einer Verstärkung der Lumineszenz von Molekülen nahe der Grenzfläche zwischen Antennenschicht und Metallschicht. Durch die Benutzung einer Antennenschicht bestehend aus orientierten Zeolith L Kristallen (Kanäle senkrecht zur Oberfläche des Metallfilms stehend), lässt sich der Abstand der Metalloberfläche zu den Akzeptor- oder Donormolekülen kontrollieren. Ein direkter Kontakt zwischen den Farbstoffmolekülen und der Metalloberfläche wird dabei vermieden. In einem konventionellen LK (bestehend aus Farbstoffmolekülen in einer Polymerschicht), sowie in allen anderen bislang bekannten LK-Konzepten, ist eine derartige Optimierung der Lumineszenzeigenschaften nicht möglich. In dem von uns entwickelten Konzept ist ein Einsatz der Oberflächen-verstärkten Plasmonresonanz zur Optimierung der Lumineszenzeigenschaften der Akzeptormoleküle besonders interessant.

### 6. LK unter Verwendung von Seltene Erden Chromophoren als Emitter

Hier schlagen wir eine neue Kombination eines Antennen-Hybridmaterials vor, bei dem ein seltenes Erd-lon als Emitter dient. Die Besonderheit dieser Kombination besteht darin, dass die Seltenen Erden Verbindungen - die vergleichsweise nur geringe Lichtabsorption aufweisen, auch wenn sie mit sogenannten Antennenliganden ausgestattet sind - über unsere Antennensysteme, die sehr hohe Lichtabsorption haben, angeregt werden können, ohne ihre Fähigkeit schmalbandig zu emittieren, zu verlieren, wie in Figur 9 und 10 erklärt. (Die in Figur 10 abgebildeten Spektren wurden der Literatur entnommen: C. Yao, H.-B. Kraatz, R. P. Steer, Photochem. Photobiol. Sci. 2005, 4, 191-199). Dabei können als Antennenabsorber auch Moleküle eingesetzt werden, die ausgesprochene NLO Eigenschaften haben, so dass mit Zweiphotonenanregung gearbeitet werden kann. Zweiphotonenanregung-Antennen können für Verwendung in der Solartechnik hochinteressant sein, aber auch für Mikroskopie bis hin zur Diagnostik (Cell-Permeant Cytoplasmic Blue Fluorophores Optimized for In Vivo Two-Photon Microscopy With Low-Power Excitation, A. Hayek, A. Grichine, T. Huault, C. Ricard, F. Bolze, B. Van Der Sanden, J.-C. Vial, Y. Mely, A. Duperray, P. L. Baldeck, J.-F. Nicoud, Microscopy Research and Technique 70, 2007, 880-885).

### 7. LK Vorrichtung für die Verwendung als Seintillations-Detektor

DMPOPOP und andere kräftig fluoreszierende Farbstoffe, die in Scintillationszählern für die Messung von ionisierender Strahlung, wie etwa Gamma-Quanten, eingesetzt werden, können-in Zeolith L in sehr hoher Konzentration, bis zu etwa 0.2 mol/L, eingebaut werden. Sie können ihre elektronische Anregungsenergie an Akzeptoren weitergeben. Für DMPOPOP können zum Beispiel PR149, DXP oder Oxonine als Akzeptoren benutzt werden. Mit Hilfe solcher Farbstoff-Zeolith L Materialien können LK, wie unter 1. bis 3. und in den Figure 4 und 5 beschrieben, gebaut werden. Solche LK werde auf den freien Seiten verspiegelt und an einer Stelle der Detektor angebracht. Damit kann auch grossflächig äusserst empfindlich ionisierende Strahlung eingefangen und in Lumineszenz des Scintillatorfarbstoffs gewandelt werden. Diese wird via Energietransfer auf den Akzeptor übertragen, der dann langwellig emittiert. Via totale interne Reflexion wird die zu messende Lumineszenz auf den Detektor übertragen. Es ist in einer solchen Vorrichtung besonders einfach und preisgünstig, den Detektor gegen einfallende ionisierende Strahlung zu schützen.

### 8. iLK für lokal gerichtete Emission

Orientierte Farbstoff-Zeolithantennen erlauben die Realisierung von gerichteter Emission (vgl dazu insbesondere G. Calzaferri, K. Lutkouskaya, Photochem. Photobiol. Sci., 2008, 7, 879 - 910. Anstelle von der Betrachtung eines Bildschirmes können damit Bilder direkt auf die Netzhaut des Auges projiziert werden, ohne externe optische Elemente. Schematisch wird das in Figur 11 illustriert: Einzelne Bildpunkte strahlen in einem definierten Winkel Alpha(i) ab. Durch die Augenlinse fällt dieser Bildpunkt auf einen bestimmten Ort auf der Netzhaut. Der Abstrahlwinkel Alpha bestimmt, auf welche Stelle auf der Netzhaut der Bildpunkt abgebildet wird. Durch geeignete Anordnung kann so ein Bild pro Auge generiert werden. Durch zwei entsprechende Bilder kann dem Betrachter ein dreidimensionales Bild übermittelt werden. Der Öffnungswinkel des Abstrahlkegels bestimmt die Pixelgrösse auf der Netzhaut und damit die Schärfe des Bildes.

### 9. LK für die Realisierung einer Augenersatz Vorrichtung

Bei sehr mangelhafter oder fehlender Augenlinse kann mit einer gerichteten Emissionsmatrix eine funktionsfähige Netzhaut direkt stimuliert werden. Hierzu wird die Emissionsmatrix sehr nahe oder direkt auf die Netzhaut aufgebracht und die gerichtete Emission direkt auf die einzelnen Lichtrezeptoren auf der Netzhaut eingespiesen. Die Bildquelle kann extern durch eine Kamera oder eine Minikamera im Auge erzeugt werden. Damit hat man einen künstlichen Augenapparat erstellt. Bei schlecht funktionierender Netzhaut kann mit diesem Verfahren die Lichtquellen-Intensität erhöht werden, so dass die Rezeptoren auf die verstärkten Lichtreize ansprechen.

### 10. iLK Vorrichtung für die Herstellung von Scheinwerfern

Die gerichtete Emission kann auch zur Erstellung eines Scheinwerfers mit definiertem Abstrahlkegelwinkel benutzt werden. In diesem Fall sind die Emissionselemente parallel anzuordnen, bei gleichem Abstrahlkegelöffnungswinkel.

## Patentansprüche

1. Vorrichtung zum Aufkonzentrieren, als Lumineszenzkonzentrator, oder Dispergieren, als Lumineszenzdispergator, von Licht, bestehend aus Lumineszenz-Zentren,
- die aus supramolekular geordneten und dergestalt organisierten Farbstoffmolekülen in Zeolithen aufgebaut sind, dass dadurch eine Antennenfunktion resultiert, welche Lumineszenz-Zentren als Antennen bezeichnet werden,
- die als eine, oder mehrere voneinander beabstandete, Lagen in ein Polymer eingebettet sind
- und die auf oder zwischen, für totale interne Reflexion geeigneten und durchsichtigen Platten, bestehend aus Glas, Kunststoff oder einer Kombination derselben, liegen,
- wobei die Dicke der Platten von der Grössenordnung einer oder einer Vielzahl dieser Lagen ist.

2. Vorrichtung nach Patentanspruch 1, **dadurch gekennzeichnet, dass** diese Vorrichtung drei Bereiche in der angegebenen Reihenfolge aufweist:
- durchsichtiges Glas, Kunststoff oder eine Kombination derselben mit Brechungsindex n₁ und Plattendicke x₁, auf welches das Licht fällt,
- eine oder mehrere, gerichtete, Farbstoff-Zeolith-Lagen, die aus den lichtabsorbierenden und lichtemittierenden Antennen bestehen,
- durchsichtiges Glas, Kunststoff oder eine Kombination derselben mit Brechungsindex n₂ und Plattendicke x₂.

3. Vorrichtung nach Patentanspruch 2, **dadurch gekennzeichnet, dass**
- die einzelnen Farbstoff-Zeolith-Lagen typisch eine Dicke zwischen 100 nm und 2000 nm aufweisen;
- die einzelnen Lagen unmittelbar aufeinander liegen oder durch relativ zur Dicke der Platten dünne Zwischenlagen eines durchsichtigen Materials getrennt sind;
- die Brechungsindexe der Zwischenlagen und des Polymers, in welches die Farbstoff-Zeolith-Lagen eingebettet sind, derart ausgewählt sind, dass eine maximale Lichtausbeute gewährleistet ist.

4. Verfahren zur Herstellung einer Vorrichtung zum Aufkonzentrieren, als Lumineszenzkonzentrator, oder Dispergieren, als Lumineszenzdispergator, von Licht, nach einem der Patentansprüche 1 oder 2 oder 3, **dadurch gekennzeichnet, dass** durch beliebig oft wiederholbares, sich abwechselndes Aufbringen von durchsichtigem Glas, Kunststoff oder einer Kombination derselben und einer oder mehreren Farbstoff-Zeolith-Lagen, Stapel hergestellt werden, wobei die Abstände zwischen den einzelnen Farbstoff-Zeolith-Lagen durch die Dicke der Zwischenlagen bestimmt werden und diese Farbstoff-Zeolith-Lagen je nach Massgabe unterschiedlich aufgebaut werden, hinsichtlich unterschiedlicher Farbstoffmoleküle, der Dicke der Farbstoff-Zeolith-Lagen und der relativen Ausrichtung der Zeolithkristalle.

5. Verwendung einer Vorrichtung nach Patentanspruch 1 zum Aufkonzentrieren von Licht, als Lumineszenzkonzentrator, **dadurch gekennzeichnet, dass** das auf dessen
Oberfläche sowohl diffus als auch direkt einfallende Licht durch die durch Antennen verursachte Frequenzverschiebung und totale interne Reflexion auf einer, mehreren oder allen Seitenflächen des Lumineszenzkonzentrators aufkonzentriert ankommt.

6. Verwendung einer Vorrichtung nach Patentanspruch 1 zum Dispergieren von Licht, als Lumineszenzdispergator **dadurch gekennzeichnet, dass** das auf einer, mehreren oder allen Seitenflächen des Lumineszenzdispergators sowohl diffus als auch direkt einfallende Licht durch die durch Antennen verursachte Frequenzverschiebung und totale interne Reflexion auf oder Oberfläche des Dispergators oder Teilen desselben abgestrahlt wird.

7. Verwendung einer Vorrichtung nach Patentanspruch 1, als Lumineszenzkonzentrator, zum Einfangen und Aufkonzentrieren von Sonnenlicht und Einspeisen in photovoltaische Energieumwandlungsanlagen.

8. Verwendung einer Vorrichtung nach Patentanspruch 1, als Lumineszenzkonzentrator, zum Einfangen und Aufkonzentrieren von Sonnenlicht und Einspeisen in Fiberoptik- Vorrichtungen.

9. Verwendung einer Vorrichtung nach Patentanspruch 1, als Lumineszenzkonzentrator, zum Einfangen und Aufkonzentrieren von Sonnenlicht und Einspeisen in photovoltaische Energieumwandlungs-Tandemsolarzellen zur Erhöhung der elektrischen Energieausbeute.

10. Verwendung einer Vorrichtung nach Patentanspruch 1, als Lumineszenzkonzentrator, zum Einfangen und Aufkonzentrieren von Sonnenlicht und Einspeisen in kombinierte Photovoltaik-Warmwasser-Vorrichtungen für die Umwandlung von Licht in elektrische und thermische Energie.

11. Verwendung einer Vorrichtung Patentanspruche 1, als Lumineszenzkonzentrator, zum Einfangen von elektromagnetischer oder Partikel-Strahlung und deren Konversion in Licht, entsprechend der Funktionsweise von Scintillations-Zählern, und dessen Transport zu einem Lumineszenz-Detektor.

12. Verwendung einer Vorrichtung nach Patentanspruch 1, als Lumineszenzdispergator, zum Illuminieren von Signalanlagen, Leuchtschriften, Raumleuchten, flächigen/diffusen Lichtquellen und von Hintergrundbeleuchtung.

13. Verwendung einer Vorrichtung nach Patentanspruch 1, als Lumineszenzdispergator, zum Erzeugen lokal gerichteter Emission für dreidimensionale Bildeindrücke in der Augenheilkunde/Ophthalmologie.

## Claims

1. A device for concentrating light, as a luminescence concentrator, or dispersing light, as a luminescence disperser, consisting of luminescent sites,
- which are formed from dye molecules in supramolecular arrangement and organized in zeolites so as to result in an antenna function, which luminescent sites are referred to as antennas,
- which are embedded as one layer, or two or more layers spaced apart, into a polymer
- and which are on or between transparent sheets which are suitable for total internal reflection and consist of glass, plastic or a combination thereof,
- wherein the thickness of the sheets is of the order of magnitude of one or more of these layers.

2. The device according to claim 1, **characterized in that** this device comprises three regions in the sequence specified:
- transparent glass, plastic or a combination thereof with refractive index n₁ and sheet thickness x₁, on which the light is incident,
- one or more directed dye-zeolite layers which consist of the light-absorbing and light-emitting antennas,
- transparent glass, plastic or a combination thereof with refractive index n₂ and sheet thickness x₂.

3. The device according to claim 2, **characterized in that**
- the individual dye-zeolite layers typically have a thickness between 100 nm and 2000 nm;
- the individual layers immediately adjoin one another or are separated by intermediate layers of a transparent material which are thin relative to the thickness of the sheets;
- the refractive indices of the intermediate layers and of the polymer into which the dye-zeolite layers are embedded are selected such that a maximum light yield is ensured.

4. A process for producing a device for concentrating light as a luminescence concentrator or dispersing light as a luminescence disperser according to any of claims 1 to 3, **characterized in that** alternating application, repeatable as often as desired, of transparent glass, plastic or a combination thereof and one or more dye-zeolite layers produces stacks, the distances between the individual dye-zeolite layers being determined by the thickness of the intermediate layers, and these dye-zeolite layers having different structures as a function of different dye molecules, of the thickness of the dye-zeolite layers and of the relative alignment of the zeolite crystals.

5. The use of a device according to claim 1 for concentrating light as a luminescence concentrator, **characterized in that** the light incident on the surface thereof, both in diffuse and direct form, arrives in concentrated form, due to the frequency shift and total internal reflection caused by antennas, on one, more than one or all side surfaces of the luminescence concentrator.

6. The use of a device according to claim 1 for dispersing light as a luminescence disperser, **characterized in that** the light incident on one, more than one or all side surfaces of the luminescence disperser, both in diffuse and direct form, is emitted on the surface of the disperser or parts thereof as a result of the frequency shift and total internal reflection caused by antennas.

7. The use of a device according to claim 1 as a luminescence concentrator, for collecting and concentrating sunlight and feeding it into photovoltaic energy conversion systems.

8. The use of a device according to claim 1 as a luminescence concentrator, for collecting and concentrating sunlight and feeding it into fiber optics devices.

9. The use of a device according to claim 1 as a luminescence concentrator, for collecting and concentrating sunlight and feeding it into photovoltaic energy conversion tandem solar cells for increasing the electrical energy yield.

10. The use of a device according to claim 1 as a luminescence concentrator, for collecting and concentrating sunlight and feeding it into combined photovoltaic hot water devices for the conversion of light to electrical and thermal energy.

11. The use of a device according to claim 1 as a luminescence concentrator, for collecting electromagnetic or particle radiation and converting it to light, correspondingly to the way scintillation counters work, and transporting it to a luminescence detector.

12. The use of a device as claimed in claim 1 as a luminescence disperser to illuminate signaling systems, illuminated signage, room lighting, flat/diffuse light sources and background illumination.

13. The use of a device as claimed in claim 1 as a luminescence disperser to obtain locally directed emission for three-dimensional imaging in ophthalmology.

## Revendications

1. Dispositif pour concentrer la lumière, sous la forme d'un concentrateur de luminescence, ou pour disperser la lumière, sous la forme d'un disperseur de luminescence, constitué de centres de luminescence,
- qui sont constitués de molécules de colorant agencées de manière supramoléculaire et organisées dans des zéolithes de telle manière qu'il en résulte une fonction d'antenne qui définit les centres de luminescence en tant qu'antennes,
- qui sont noyés dans un polymère sous la forme d'une ou plusieurs couches mutuellement espacées,
- et qui se situent sur ou entre des plaques aptes à produire une réflexion interne totale et transparentes constituées de verre, de matière plastique ou d'une combinaison de ceux-ci,
- l'épaisseur des plaques étant de l'ordre de grandeur d'une ou d'une pluralité de ces couches.

2. Dispositif selon la revendication 1, **caractérisé en ce que** ledit dispositif comporte trois régions dans l'ordre suivait :
- un verre transparent, une matière plastique transparente ou une combinaison de ceux-ci, ayant un indice de réfraction n₁ et une épaisseur de plaque x₁, sur lequel la lumière est incidente,
- une ou plusieurs couches orientées de zéolithe contenant un colorant, qui sont constituées des antennes absorbant la lumière et émettant de la lumière,
- un verre transparent, une matière plastique transparente ou une combinaison de ceux-ci ayant un indice de réfraction n₂ et une épaisseur de plaque x₂.

3. Dispositif selon la revendication 2, **caractérisé en ce que**
- les couches individuelles de zéolithe contenant un colorant ont une épaisseur type comprise entre 100 nm et 2000 nm ;
- les couches individuelles sont contigües ou séparées par des couches intermédiaires relativement minces par rapport à l'épaisseur des plaques et constituées d'un matériau transparent ;
- l'indice de réfraction des couches intermédiaires et du polymère dans lequel sont noyées les couches de zéolithe contenant un colorant est sélectionné de manière à garantir un rendement lumineux maximal.

4. Procédé de fabrication d'un dispositif destiné à concentrer la lumière, sous la forme d'un concentrateur de luminescence, ou à disperser la lumière, sous la forme d'un disperseur de luminescence, selon la revendication 1 ou 2 ou 3, **caractérisé en ce que** des empilements sont produits par un dépôt pouvant être répété aussi souvent que nécessaire et de manière alternée de verre transparent, de matière plastique transparente ou d'une combinaison de ceux-ci et d'une ou plusieurs couches de zéolithe contenant un colorant, la distance entre les couches individuelles de zéolithe contenant un colorant étant déterminée par l'épaisseur des couches intermédiaires et ces couches de zéolithe contenant un colorant étant chacune réalisées de manière différente en ce qui concerne les différentes molécules de colorant, l'épaisseur des couches de zéolithe contenant un colorant et l'orientation relative des cristaux de zéolithe.

5. Utilisation d'un dispositif selon la revendication 1, pour concentrer la lumière, sous la forme d'un concentrateur de luminescence, **caractérisée en ce que** la lumière incidente de manière diffuse ou directe sur sa surface arrive à l'état concentré du fait du décalage de fréquence induit par les antennes et de la réflexion interne totale sur une, plusieurs ou la totalité des surfaces latérales du concentrateur de luminescence.

6. Utilisation d'un dispositif selon la revendication 1, pour disperser la lumière, sous la forme d'un disperseur de luminescence, **caractérisée en ce que** la lumière incidente de manière diffuse ou directe sur une, plusieurs ou la totalité des surfaces latérales du disperseur de luminescence, est rayonnée du fait du décalage de fréquence induit par les antennes et de la réflexion interne totale sur la surface du disperseur ou des parties de celui-ci.

7. Utilisation d'un dispositif selon la revendication 1, en tant que concentrateur de luminescence, pour capter et concentrer la lumière solaire et la fournir à des installations photovoltaïques de conversion d'énergie.

8. Utilisation d'un dispositif selon la revendication 1, en tant que concentrateur de luminescence, pour capter et concentrer la lumière solaire et la fournir à des dispositifs à fibre optique.

9. Utilisation d'un dispositif selon la revendication 1, en tant que concentrateur de luminescence, pour capter et concentrer la lumière solaire et la fournir à des cellules solaires photovoltaïques de conversion d'énergie en tandem afin d'augmenter le rendement en énergie électrique.

10. Utilisation d'un dispositif selon la revendication 1, en tant que concentrateur de luminescence, pour capter et concentrer la lumière solaire et à la fournir à des dispositifs photovoltaïques de chauffage d'eau pour la conversion de lumière en énergie électrique et thermique.

11. Utilisation d'un dispositif selon la revendication 1, en tant que concentrateur de luminescence, pour capter un rayonnement électromagnétique ou de particules et le convertir en lumière d'une manière qui correspond au mode de fonctionnement de compteurs à scintillations, et l'acheminer vers un détecteur de luminescence.

12. Utilisation d'un dispositif selon la revendication 1, en tant que disperseur de luminescence, pour éclairer des panneaux de signalisation, des enseignes lumineuses, des luminaires, des sources de lumière planes/diffuses et des rétroéclairages.

13. Utilisation d'un dispositif selon la revendication 1, en tant que disperseur de luminescence, pour générer une émission dirigée localement afin de procurer une impression d'image tridimensionnelle en ophtalmologie.
